# EUROPÄISCHE PATENTANMELDUNG

(11) **EP 4 554 096 A1**
(43) Veröffentlichungstag der Anmeldung: **14.05.2025**
(21) Anmeldenummer: 24191063.7
(22) Anmeldetag: 26.07.2024
(51) Int. Cl.: H03K 17/97, H03K 17/972

(54) **BEDIENVORRICHTUNG FÜR EIN KRAFTFAHRZEUG**

(30) Priorität: 07.11.2023 DE 102023130717
(71) Anmelder: HUF Hülsbeck & Fürst GmbH & Co. KG, 42551 Velbert (DE)
(72) Erfinder: Chabrowski, Christian, 45472 Mülheim (DE)
(74) Vertreter: Zenz Patentanwälte Partnerschaft mbB

(57) **Zusammenfassung**

Bedienvorrichtung für ein Kraftfahrzeug mit einem Gehäuse (1), in dem mindestens zwei induktive Sensorbereiche (5, 6) angeordnet sind, denen jeweils ein metallisches Target (5a, 6a) zugeordnet ist. Eine Krafteinwirkung auf Betätigungsbereiche (7a, 7b) bewirkt eine Abstandsänderung zwischen dem zugeordneten induktiven Sensorbereich (5, 6) und seinem zugeordneten Target (5a, 6a).

Die induktiven Sensorbereiche (5, 6) sind über Signalleitungen (4a, 4b) miteinander und über gemeinsame Kontakte in Parallelschaltung mit einer Steuerschaltung (4) gekoppelt.

Der erste Sensorbereich (5) und sein zugeordnetes Target (5a) sind mechanisch derart gekoppelt, dass eine Krafteinwirkung auf den zugeordneten Bedienbereich eine Verringerung des Abstands zwischen dem ersten induktiven Sensorbereich (5) und seinem zugeordneten Target (5a) bewirkt, wobei der zweite Sensorbereich (6) der induktiven Sensorbereiche bzw. dessen zugeordnetes Target (6a) über eine mechanische Umlenkeinrichtung (8, 9) mit dem zugeordneten Bedienbereich (7b) gekoppelt ist, so dass eine Krafteinwirkung auf den zugeordneten Bedienbereich eine Vergrößerung des Abstandes zwischen dem zweiten induktiven Sensorbereich (6) und dessen zugeordnetem Target (6a) bewirkt.

## Beschreibung

Die Erfindung betrifft eine Bedienvorrichtung für ein Kraftfahrzeug. Insbesondere betrifft die Erfindung eine Bedienvorrichtung für ein Kraftfahrzeug, bei der in dem Gehäuse der Bedienvorrichtung wenigstens zwei induktive Sensorbereiche angeordnet sind. Jedem der induktiven Sensorbereiche ist jeweils ein metallisches Target zugeordnet, welches jeweils beabstandet zu dem zugeordneten induktiven Sensorbereich in dem Gehäuse angeordnet ist.

Induktive Sensoren, auch induktive Näherungsschalter oder Initiatoren genannt, sind in der Automatisierungs- und Verfahrenstechnik und in der Automobilindustrie weit verbreitet und werden für verschiedene Anwendungen in Fahrzeugen eingesetzt. Sie nutzen das Prinzip der Induktion, um Änderungen in einem elektrischen Feld zu erfassen, die durch die Anwesenheit von Metall oder elektrisch leitfähigen Materialien verursacht werden. Induktive Sensoren arbeiten nach dem Prinzip der Impedanzänderung, die durch Wirbelströme in einem leitfähigen Ziel verursacht wird. Der Sensor wird von einem Oszillator angeregt, wodurch ein elektromagnetisches Feld erzeugt wird, das mit dem (galvanisch entkoppelten) Target koppelt. Eine Signalverarbeitungselektronik erfasst die Impedanzänderung, wenn sich der Abstand zwischen Sensor und Target ändert, und wandelt sie in ein nutzbares Verschiebungssignal um. Die Verarbeitung der Signale kann mithilfe von einem Schaltkreis erfolgen, welche z.B. von den einer Nutzung oder Kombination der folgenden Schaltkreistypen abgeleitet ist: Colpitts-Schaltung, Phasenschaltung und Brückenschaltung (z.B. Maxwell-Brücke).

Induktive Sensoren werden häufig zur Erfassung der Raddrehzahl in modernen Fahrzeugen eingesetzt. Diese Sensoren befinden sich in der Nähe der Räder und messen mittels Induktion die Anzahl der Umdrehungen pro Minute. Diese Information ist entscheidend für das Antiblockiersystem (ABS), die Antriebsschlupfregelung und andere Fahrzeugstabilitätssysteme. Induktive Sensoren können auch verwendet werden, um den Abstand zwischen einem Fahrzeug und einem Hindernis zu messen. Diese Sensoren werden häufig in Einparkhilfesystemen eingesetzt, um den Fahrer beim sicheren Einparken zu unterstützen und Kollisionen zu vermeiden. Induktive Sensoren können auch in Fahrzeugtüren und Kofferraumdeckeln eingesetzt werden, um festzustellen, ob diese richtig geschlossen sind.

Induktive Sensoren haben den Vorteil, dass sie berührungslos arbeiten und kaum anfällig für Verschleiß und Verschmutzung sind. Sie zeichnen sich durch hohe Zuverlässigkeit aus und arbeiten berührungslos, kontakt- und rückwirkungsfrei.

Das induktive Element eines solchen Sensors ist eine Leiterspule, die bei Stromfluss ein Magnetfeld erzeugt. Das Magnetfeld wirkt in einem räumlich begrenzten Bereich einer aktiven Schaltzone. Wird ein Target (z.B. eine Metallplatte) in diesen Bereich gebracht, so wird das Magnetfeld deformiert oder gedämpft. Durch die Änderung des Magnetfeldes erfährt die Spule eine Änderung der Impedanz.

Im Rahmen dieser Anmeldung wird der Begriff "Sensorbereich" verwendet, um die Ausbildung eines induktiven Elements zu beschreiben. Der Begriff umfasst also wenigstens ein induktives Element, kann aber noch weitere bauliche Komponenten oder mechanische Strukturen aufweisen. Dieser Begriff wird in Abgrenzung zum Begriff "Sensor" verwendet, da ein Sensor im Kontext dieser Anmeldung mehrere, getrennt auswertbare Sensorbereiche aufweisen kann. Ein Sensorbereich kann insbesondere eine Sensorfläche oder ein integriertes induktives Bauelement umfassen, welches in dem Sensorbereich angeordnet wird. Das zum Sensorbereich zugeordnete Target, welches mit dem induktiven Element wechselwirkt ist in räumlicher Nachbarschaft zum Sensorbereich angeordnet, so dass es die Induktivität des induktiven Elements im Sensorbereich auswertbar beeinflusst.

Sowohl die induktiven Sensorbereiche als auch die Targets sind in der Bedienvorrichtung so angeordnet, dass eine Krafteinwirkung auf Bedienflächen des Gehäuses, die im Erfassungsbereich eines der Sensorbereiche liegen, eine Abstandsänderung zwischen dem zugeordneten induktiven Sensorbereich und seinem zugeordneten Target und damit eine Änderung der Induktivitäten des jeweiligen induktiven Sensorbereichs zur Folge hat. Eine Krafteinwirkung kann das Gehäuse selbst oder besonders verformbar gestaltete Bereiche, z.B. weiche Bauteile, die im Gehäuse angeordnet sind, verformen. Die Abstandsänderung kann dadurch bewirkt werden, dass das Target am Gehäuse selbst befestigt ist und durch die Verformung des Gehäuses im Wirkbereich auf den zugeordneten induktiven Sensorbereich zu oder von diesem weg bewegt wird. Alternativ kann prinzipiell auch der Sensorbereich selbst durch die Krafteinwirkung bewegt werden, wobei entscheidend ist, dass ein Bedienvorgang mit Krafteinwirkung auf die Bedieneinrichtung zu einer Abstandsänderung zwischen Target und zugeordnetem induktiven Sensorbereich führt. Die induktiven Sensorbereiche werden über eine Steuerschaltung angesteuert und abgefragt, wobei verschiedene Verfahren zur Auswertung der jeweiligen Induktivitäten in den Sensorbereichen in Frage kommen. So kann z.B. das analoge Ausgangssignal des Sensorbereichs verwendet werden, das eine induzierte Spannung in Abhängigkeit von der Bewegung eines metallischen Elements relativ zum Sensorbereich anzeigt. Induktive Sensoren können auch anhand ihres Frequenzverhaltens bei Anregung ausgewertet werden. Wenn sich ein metallisches Objekt in der Nähe des Sensors befindet, ändert sich die Schwingungsfrequenz, da sich die Induktivität ändert. Die Frequenzänderung wird gemessen und kann zur Metalldetektion oder zur Positionsbestimmung genutzt werden.
Auch die Änderung der Phasenverschiebung eines Signals kann zur Auswertung sich ändernder Induktivitäten genutzt werden. Die Phasenverschiebung ändert sich, wenn sich ein metallisches Objekt bewegt oder wenn sich die Induktivität eines Sensorbereichs ändert. Auf die verschiedenen Auswerteverfahren wird an dieser Stelle nicht weiter eingegangen, da die Auswertung induktiver Sensoren grundsätzlich bekannt ist.

Induktive Sensorbereiche sind in der Regel mit einer jeweils zugeordneten Steuerschaltung gekoppelt, so dass die Steuerschaltung die Sensorbereiche sequenziell oder auch zeitlich parallel abfragt. Dies ist zum einen zeitaufwendig und erfordert eine Steuerschaltung mit einer entsprechenden Anzahl von Steuer- und Signalkontakten.

Aufgabe der Erfindung ist es, eine Bedienvorrichtung bereitzustellen, die den bewährten Aufbau der induktiven Sensorbereiche mit reduzierter Auswertekomplexität und optimierter Auswertezeit ermöglicht.

Diese Aufgabe wird durch eine Bedienvorrichtung mit den Merkmalen des Patentanspruchs 1 gelöst.

Die erfindungsgemäße Bedienvorrichtung weist mindestens zwei induktive Sensorbereiche auf, die mit einer gemeinsamen Ansteuerschaltung gekoppelt sind. Die induktiven Sensorbereiche sind über Signalleitungen miteinander und über gemeinsame Kontakte mit der gemeinsamen Steuerschaltung derart gekoppelt, dass sich eine Parallelschaltung der induktiven Sensorbereiche zu der gemeinsamen Steuerschaltung ergibt. Dabei werden die Signale der induktiven Sensorbereiche über gemeinsame Signalleitungen erfasst.

Bei dieser erfindungsgemäßen Ausgestaltung und Verschaltung werden die induktiven Sensorbereiche gegenüber der Steuerschaltung nicht durch eine getrennte Signalkopplung als getrennte Sensorbereiche erkennbar gemacht, sondern die Steuerschaltung nimmt die jeweils getrennt ausgebildeten und mit jeweiligen Bedienbereichen versehenen induktiven Sensorbereiche einheitlich wahr. Durch die Parallelschaltung der induktiven Sensorbereiche ergibt sich eine resultierende Gesamtinduktivität, die nach den bekannten Prinzipien der Parallelschaltung von Induktivitäten berechnet wird.

Erfindungsgemäß ist ein erster Sensorbereich der induktiven Sensorbereiche bzw. dessen zugeordnetes Target mit dem zugeordneten Bedienbereich derart mechanisch gekoppelt, dass eine Krafteinwirkung auf den zugeordneten Bedienbereich eine Verringerung des Abstands zwischen dem ersten induktiven Sensorbereich und dessen zugeordnetem Target bewirkt. Dies kann z.B. dadurch erreicht werden, dass das Target auf der Innenseite des Gehäuses angeordnet ist, während sich der zugeordnete Sensorbereich auf einer Platine innerhalb des Gehäuses unterhalb des Targets befindet. Ein Druck auf den Bedienbereich des Gehäuses verformt dieses und bringt das Target näher an den Sensorbereich, in dem sich daraufhin die Induktivität ändert.

Demgegenüber ist erfindungsgemäß ein zweiter Sensorbereich der induktiven Sensorbereiche bzw. dessen zugeordnetes Target über eine mechanische Umlenkeinrichtung mit dem zugeordneten Bedienbereich gekoppelt, so dass eine Krafteinwirkung auf den zugeordneten Bedienbereich eine Vergrößerung des Abstands zwischen dem zweiten induktiven Sensorbereich und dessen zugeordnetem Target bewirkt.

Die Krafteinwirkung auf den zweiten Sensorbereich wird somit in eine Bewegung umgesetzt, so dass der Abstand zwischen Target und Sensorbereich vergrößert wird. Dabei kann der Sensorbereich bewegt oder das Target oder beide Komponenten voneinander wegbewegt werden.

Da die Signaländerung bei induktiven Sensoren sehr empfindlich auf Abstandsänderungen eines metallischen Targets gegenüber dem detektierenden induktiven Element reagiert, kann im Rahmen der Erfindung eine einfache mechanische Umlenkung, die nur eine geringe Positionsänderung bewirkt, völlig ausreichend sein.

Induktive Sensoren reagieren regelmäßig bereits auf Positionsänderungen im Mikrometerbereich. Beispiele für entsprechende Umlenkeinrichtungen sind bewegliche Hebel, Wippen oder Schwenkeinrichtungen.

Die induktiven Sensorbereiche werden von der Ansteuerschaltung zwar grundsätzlich als einheitliche Induktivität wahrgenommen, unterscheiden sich jedoch hinsichtlich ihrer Signalerzeugung. Während die Betätigung eines ersten Bedienteils, das dem ersten Sensorbereich zugeordnet ist, ein Signal liefert, das die Annäherung eines Targets an die Induktivität signalisiert, liefert die Betätigung des zweiten Bedienteils, das dem zweiten Sensorbereich zugeordnet ist, ein Signal, das der Entfernung des Targets von der Induktivität entspricht.

Die Steuerschaltung kann somit anhand der Signaländerung den auslösenden induktiven Sensor identifizieren, obwohl dieser mit dem anderen induktiven Sensor parallel geschaltet ist und eine gemeinsame Induktivität bildet. Anhand der Signaländerung, die durch die unterschiedliche Abstandsänderung (Annäherung bzw. Entfernung) der induktiven Sensoren zum jeweils zugeordneten Ziel hervorgerufen wird, ist es möglich, die Signale von zwei induktiven Sensoren in einer einheitlichen, simultanen Messung zu erfassen und zu differenzieren. Dies spart zum einen Zeit und reduziert zum anderen den Aufwand bei der Auswertung in der Steuerschaltung.

In einer bevorzugten Ausführungsform der Erfindung sind die induktiven Sensorbereiche mit gleicher räumlicher Orientierung auf einer gemeinsamen Leiterplatte angeordnet.

Dies ermöglicht eine besonders einfache Platzierung und Bestückung der Sensorbereiche auf der Leiterplatte.

In einer Weiterbildung der Erfindung sind die induktiven Sensoren jeweils als gedruckte Leiterspiralen auf einer gemeinsamen Leiterplatte aufgedruckt.

Diese Anordnung ist besonders einfach herzustellen, da die induktiven Sensoren aus gedruckten Leiterbahnen bestehen.

In einer bevorzugten Ausgestaltung der Erfindung sind die induktiven Sensoren jeweils mit gleichen Induktivitäten ausgebildet.

Während die Erfindung grundsätzlich auch wirksam ist, wenn die induktiven Sensoren unterschiedliche Induktivitäten aufweisen, ist die Auswertung hinsichtlich Signalanstieg und Signalabfall besonders einfach, wenn einheitliche Induktivitäten vorliegen. Auch die Herstellung einer erfindungsgemäßen Bedienvorrichtung erfordert in diesem Fall weniger unterschiedliche Bauteile.

In einer bevorzugten Ausgestaltung der Erfindung ist die mechanische Umlenkeinrichtung mit einer Wippe ausgebildet, an deren einem Arm das dem zweiten Sensorbereich zugeordnete Target angeordnet ist und an deren anderem Arm der dem zweiten Sensorbereich zugeordnete Bedienbereich einwirkt.

Eine solche Wippe, die eine Bewegung von wenigen Mikrometern umlenken muss, kann in einfacher Weise, beispielsweise aus Komponenten des Gehäuses, gebildet werden. Es kann z.B. vorgesehen sein, dass im Inneren des Gehäuses ein Arm aus dem Gehäusematerial von dem Bedienbereich absteht. Der Arm kann in einem mittleren Abschnitt auf einem Lager abgestützt sein, so dass ein Druck auf den Arm an seinem Ende, das an dem Bedienbereich befestigt ist, zu einer Bewegung des Abschnitts des Arms auf der anderen Seite des Lagers in die entgegengesetzte Richtung führt. An diesem anderen Teil kann das Target befestigt sein. Ein entsprechendes Beispiel ist unten dargestellt.

Die Erfindung wird nun anhand eines in den beigefügten Zeichnungen dargestellten Ausführungsbeispiels näher erläutert.
Figur 1a zeigt schematisch einen Fahrzeugtürgriff, in dem eine Bedienvorrichtung
Figur 1b zeigt schematisch einen Fahrzeugtürgriff, in dem eine Bedienvorrichtung gemäß dem ersten Ausführungsbeispiel in einem Bedienungszustand aufgenommen ist.
Figur 2 zeigt schematisch eine Leiterplatte mit zwei Sensorbereichen in einer Draufsicht.
Figur 3 zeigt schematisch die Signalverläufe bei Betätigung der Bedienvorrichtung gemäß dem ersten Ausführungsbeispiel.

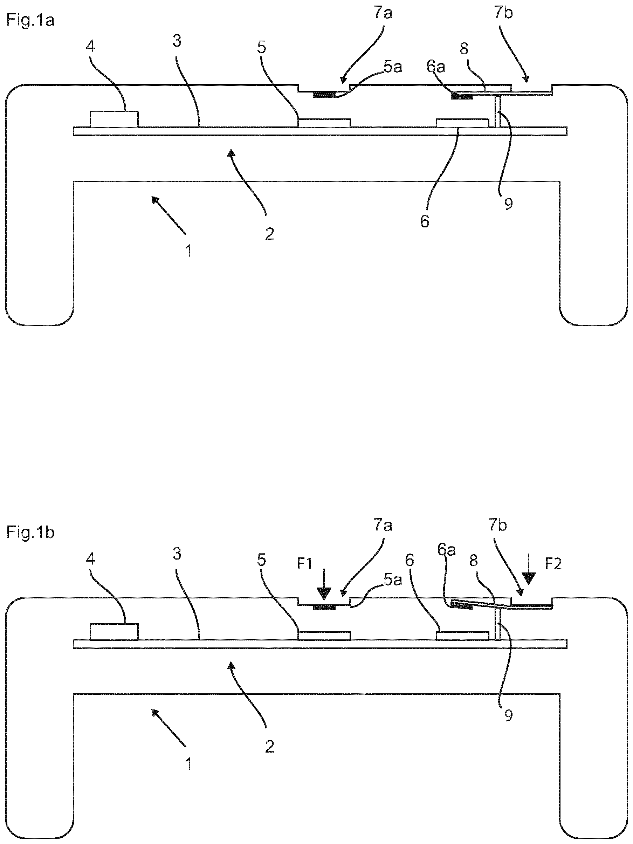

Figur 1a zeigt ein Fahrzeugtürgriffgehäuse 1, in dessen Innenraum eine Bedienvorrichtung 2 gemäß dem ersten Ausführungsbeispiel aufgenommen ist. Die Bedienvorrichtung kann innerhalb des Gehäuses in entsprechende Aufnahmen eingeklebt oder eingeclipst oder auf andere Weise innerhalb des Gehäuses stabil befestigt sein. Es sind zwei Bedienbereiche 7a und 7b vorgesehen, die in dem Gehäuse des Fahrzeugtürgriffgehäuses 1 ausgebildet sind, wobei die Bedienbereiche 7a und 7b für einen Benutzer optisch und/oder haptisch erkennbar sind. Sie können insbesondere aus einem weichen, verformbaren Material gebildet sein. Auf der Unterseite des Bedienbereichs 7a, d.h. auf der der Bedienvorrichtung 2 zugewandten Seite, ist ein Target 5a angeordnet, das zusammen mit dem darunter angeordneten Sensorbereich 5, der eine spiralförmige Leiterspule aufweist, einen induktiven Sensor 5, 5a bildet.

Der Bedienbereich 7 ist an seiner Unterseite mit einer Wippe 8 gekoppelt, wobei ein Arm der Wippe 8 an der Innenseite des Gehäuses angeklebt sein kann und di Wippe aus einem elastisch verformbaren Material, beispielsweise einem Kunststoff, besteht. Auf der Platine 2 (alternativ im Gehäuse selbst) ist ein Stützlager 9 ausgebildet, das mit der Wippe 8 in Kontakt steht. Wird Druck auf den Bedienbereich 7b ausgeübt, so bewegt sich der rechte Arm der Wippe 8 auf der rechten Seite des Stützlagers 9 nach unten, während sich der linke Arm der Wippe 8 auf der linken Seite des Stützlagers 9 nach oben bewegt. Ein an dem der Wippe 8 im linken Armabschnitt befestigtes Target 6a wird bei Krafteinwirkung auf den Bedienbereich 7b entsprechend leicht nach oben, d.h. von dem darunter liegenden Sensorbereich 6 wegbewegt. Dieser Zustand ist in Bild 1b dargestellt. Bei Rückverformung des Gehäuses nach Wegnahme der Betätigungskraft kehrt die Wippe 8 wieder in ihre Ausgangslage gemäß Fig. 1a zurück.

Die Targets 5a und 6a sind somit beide mit den Bedienbereichen 7a und 7b gekoppelt, so dass sie bei Krafteinwirkung durch eine der Kräfte F1 oder F2 relativ zu den Sensorbereichen 5 und 6 bewegt werden. Die Targets sind dabei aus einem metallischen Werkstoff gebildet.

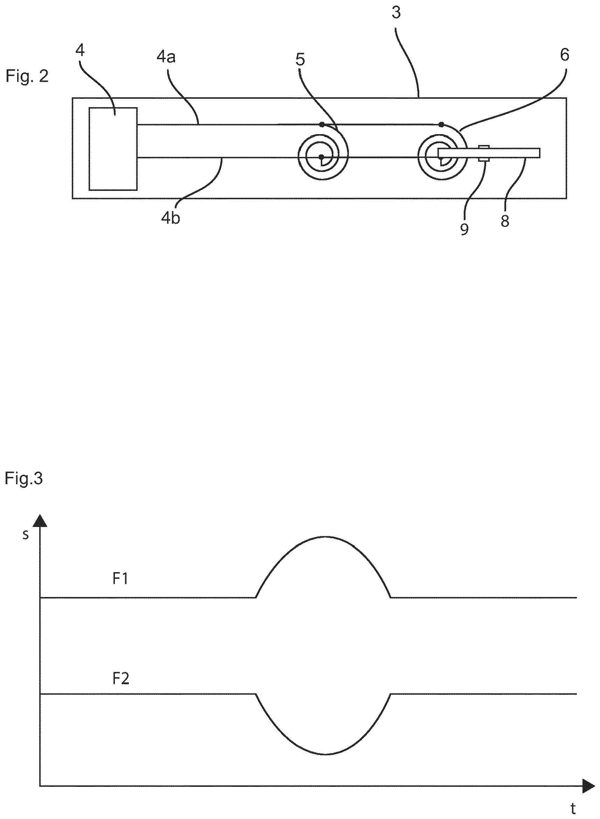

Die Bedienvorrichtung 2 weist als Grundplatte eine Platine 3 auf, auf der eine Steuerschaltung 4 mit einem Mikrocontroller sowie spiralförmige Leiterspulen als gedruckte Leiterbahnen zur Bildung der Sensorbereiche 5 und 6 angeordnet sind. Figur 2 zeigt, dass die Sensorbereiche 5 und 6 mit den spiralförmigen Leiterspulen als induktive Elemente auf der Platine 3 in deren Ebene angeordnet sind. Die Steuerschaltung 4 ist über elektrische Leitungen 4a und 4b mit den Induktivitäten der Sensorbereiche 5 und 6 gekoppelt, wobei eine Parallelschaltung realisiert ist.

Damit ist die Funktion als Sensor mit zwei trotz Parallelschaltung unterscheidbaren Sensorbereichen 5, 6 realisiert. Wirkt eine Kraft F1 auf einen Bedienbereich 7a, so nähert sich das Target 5a mit seiner spiralförmigen Leiterspule dem Sensorbereich 5. Wirkt eine Kraft F2 auf den Bedienbereich 7b, so entfernt sich das Target 6a vom Sensorbereich 6 mit seiner spiralförmigen Leiterspule. Obwohl die Richtung der Betätigungskraft in beiden Fällen gleich ist, kann die Steuerschaltung 4 anhand der Signaländerung erkennen, ob die Kraft F1 oder die Kraft F2 gewirkt hat, also insbesondere ob der Bedienbereich 7a oder der Bedienbereich 7b mit einer Betätigungskraft beaufschlagt wurde.

In Figur 3 ist beispielhaft dargestellt, wie sich eine Betätigung in einem Bedienbereich 7a von einer Betätigung in einem Bedienbereich 7b unterscheidet, nämlich einerseits in einem Signalanstieg bei Betätigung mit der Kraft F1, während gleichzeitig eine Kraft F2 zu einem Signalabfall führen würde. Die Art der Signaländerung hängt insbesondere vom gewählten Auswerteverfahren ab. Im Rahmen des Fachwissens ist es ohne weiteres möglich, geeignete Auswerteverfahren zu bestimmen, die zu einer Unterscheidbarkeit der Signale führen. Auf diese Weise ist die Steuerschaltung 4 in der Lage, trotz der Parallelschaltung zweier Induktivitäten die Auslösung des ersten Sensorbereichs 5 von der Auslösung des zweiten Sensorbereichs 6 zu unterscheiden.

## Patentansprüche

1. Bedienvorrichtung für ein Kraftfahrzeug, mit einem Gehäuse (1), in dem wenigstens zwei induktive Sensorbereiche (5, 6) angeordnet sind,
wobei jedem der induktiven Sensorbereiche (5, 6) jeweils ein metallisches Target (5a, 6a) zugeordnet ist, welches beabstandet zu dem jeweils zugeordneten induktiven Sensorbereich (5, 6) angeordnet ist,
wobei die induktiven Sensorbereiche (5, 6) und die zugeordneten Targets (5, 6) derart in dem Gehäuse (1) angeordnet sind, dass eine Krafteinwirkung auf Bedienbereiche (7a, 7b), welche den induktiven Sensorbereichen (5, 6) jeweils zugeordneten sind, zu einer Abstandsänderung zwischen dem zugeordneten induktiven Sensorbereich (5, 6) und seinem zugeordneten Target (5a, 6a) führt, und damit zu einer Veränderung einer Induktivität des jeweiligen induktiven Sensorbereiches,
**dadurch gekennzeichnet,**
**dass** die wenigstens zwei induktiven Sensorbereiche (5, 6) mit einer gemeinsamen Steuerschaltung (4) gekoppelt sind,
wobei die induktiven Sensorbereiche (5, 6) über Signalleitungen (4a, 4b) miteinander und über gemeinsame Kontakte mit der gemeinsamen Steuerschaltung (4) derart gekoppelt sind, dass die induktiven Sensorbereiche (5, 6) in einer Parallelschaltung mit der gemeinsamen Steuerschaltung (4) gekoppelt sind, so dass diese die Signale der induktiven Sensorbereiche (5, 6) über dieselben Signalleitungen erfasst,
wobei ein erster Sensorbereich (5) der induktiven Sensorbereiche oder dessen zugeordnetes Target (5a) mit dem zugeordneten Bedienbereich (7a) derart mechanisch gekoppelt ist, dass eine Krafteinwirkung auf den zugeordneten Bedienbereich eine Verringerung des Abstandes zwischen dem ersten induktiven Sensorbereich (5) und dessen zugeordnetem Target (5a) bewirkt,
wobei ein zweiter Sensorbereich (6) der induktiven Sensorbereiche oder dessen zugeordnetes Target (6a) mit dem zugeordneten Bedienbereich (7b) über eine mechanische Umlenkungsvorrichtung (8,9) derart gekoppelt ist, dass eine Krafteinwirkung auf den zugeordneten Bedienbereich eine Vergrößerung des Abstandes zwischen dem zweiten induktiven Sensorbereich (6) und dessen zugeordnetem Target (6a) bewirkt.

2. Bedienvorrichtung nach Anspruch 1, wobei die induktiven Sensorbereiche (5, 6) mit derselben Raumorientierung auf einer gemeinsamen Platine (3) angeordnet sind.

3. Bedienvorrichtung nach Anspruch 2, wobei die induktiven Sensorbereiche (5, 6) jeweils eine gedruckte Leiterspirale als Induktionsspule aufweisen.

4. Bedienvorrichtung nach einem der vorangehenden Ansprüche, wobei die induktiven Sensorbereiche jeweils die gleiche Induktivität aufweisen.

5. Bedienvorrichtung nach einem der vorangehenden Ansprüche, wobei die mechanische Umlenkvorrichtung eine Wippe (8) aufweist, an deren einem Arm das dem zweiten Sensorbereich (6) zugeordnete Target (6a) angeordnet ist und auf deren anderem Arm der Bedienbereich (7b) einwirkt, welcher dem zweiten Sensorbereich (6) zugeordnet ist.

6. Bedienvorrichtung nach einem der Ansprüche 1 bis 4, wobei die mechanische eine Wirkverbindung zwischen dem Bedienbereich, welcher dem zweiten Sensorbereich zugeordnet ist und dem zweiten Sensorbereich aufweist, so dass bei Krafteinwirkung auf den Bedienbereich, der zweite Sensorbereich in seiner Raumlage verschoben wird, um den Abstand des zweiten Sensorbereichs von dem zugeordneten Target zu vergrößern.
